# EUROPEAN PATENT APPLICATION

(11) **EP 4 354 520 A1**
(43) Date of publication of application: **17.04.2024**
(21) Application number: 23793978.0
(22) Date of filing: 24.04.2023
(51) Int. Cl.: H01L 31/048

(54) **PHOTOVOLTAIC ASSEMBLY**

(30) Priority: 19.08.2022 CN 202222196111 U
(71) Applicant: Trina Solar Co., Ltd, Changzhou, Jiangsu 213000 (CN)
(72) Inventor: The designation of the inventor has not yet been filed
(74) Representative: Canzler & Bergmeier Patentanwälte Partnerschaft mbB
(86) International application number: PCT/CN2023/090213
(87) International publication number: WO 2024/037022

(57) **Abstract**

Disclosed is a photovoltaic module including a first photovoltaic module and a stiffening member. The stiffening member is provided on a back surface of the first photovoltaic module and configured to enhance mechanical properties of the first photovoltaic module.

## Description

### TECHNICAL FIELD

The present disclosure relates to the field of photovoltaic technology, and in particular relates to a photovoltaic module.

### BACKGROUND

As a core part of a solar power generation system, the photovoltaic module can convert solar energy into electric energy to push a load to work or store the electric energy in a storage battery.

How to obtain a photovoltaic module with enhanced mechanical properties without reducing the power generation efficiency of the photovoltaic module or increasing the processing difficulty has become an urgent technical problem to be solved by those skilled in the art.

### SUMMARY

The present disclosure provides a photovoltaic module which can enhance mechanical properties of the photovoltaic module without increasing the thickness of photovoltaic front glass, so that the photovoltaic module can be suitable for the building industry.

To achieve the above object, the present disclosure provides a photovoltaic module, including a first photovoltaic module and a stiffening member, wherein the stiffening member is provided on a back surface of the first photovoltaic module and configured to enhance mechanical properties of the first photovoltaic module.

In some embodiments, the stiffening member is a stiffening plate.

In some embodiments, the stiffening member is a single layer of the stiffening plate; or, the stiffening member is a stiffening plate assembly including at least two layers of the stiffening plates arranged in a stacked manner.

In some embodiments, the at least two layers of the stiffening plates of the stiffening plate assembly have the same shape.

In some embodiments, the at least two layers of the stiffening plates of the stiffening plate assembly have the same size.

In some embodiments, the at least two layers of the stiffening plates of the stiffening plate assembly are made of the same material.

In some embodiments, any two adjacent layers of the stiffening plates of the stiffening plate assembly are connected via a second adhesive layer.

In some embodiments, the stiffening plate is a glass plate, a concrete plate, a steel plate, or a plastic plate.

In some embodiments, the stiffening member is a second photovoltaic module, and a back surface of the second photovoltaic module is connected to the back surface of the first photovoltaic module.

In some embodiments, the second photovoltaic module and the first photovoltaic module are of the same type or different types.

In some embodiments, the second photovoltaic module is a crystalline silicon solar cell module.

In some embodiments, the second photovoltaic module is a thin film solar cell module.

In some embodiments, the stiffening member is connected to the back surface of the first photovoltaic module via a first adhesive layer.

In some embodiments, the mechanical properties include strength.

To achieve the above object, the present disclosure further provides a photovoltaic module composite structure, including: a first photovoltaic module configured to generate electricity with illumination; and a stiffening member connected to a back surface of the first photovoltaic module; wherein the back surface is a surface of the first photovoltaic module facing away from a light receiving surface; and an overall strength of the stiffening member and the first photovoltaic module is greater than a strength of the first photovoltaic module.

In some embodiments, the stiffening member includes a stiffening structural member; or, the stiffening member includes the second photovoltaic module is used for generating electricity by utilizing illumination.

In some embodiments, the stiffening member is bonded to the back surface of the first photovoltaic module via a first adhesive layer.

To achieve the above object, the present disclosure further provides a method for preparing a photovoltaic module composite structure, wherein the photovoltaic module composite structure is the photovoltaic module composite structure according to any embodiment of the present disclosure, and the method includes: providing the first photovoltaic module and the stiffening member, respectively; and connecting the stiffening member to the back surface of the first photovoltaic module.

In the photovoltaic module (or photovoltaic module composite structure) according to the embodiments of the present disclosure, the stiffening member is provided on the back surface of the first photovoltaic module. With the stiffening member provided on the back surface of the first photovoltaic module, the light transmittance on the front surface of the first photovoltaic module is not affected, and the power generation efficiency of the first photovoltaic module is ensured. Instead of the thickened front and rear photovoltaic glass, a separate stiffening member is used to enhance the mechanical properties (e.g., strength) of the first photovoltaic module, which will not increase the processing difficulty of the first photovoltaic module. The stiffening member itself has certain mechanical properties, and when the stiffening member is provided on the back surface of the first photovoltaic module, mechanical properties of the first photovoltaic module and the stiffening member are added to obtain a photovoltaic module with enhanced mechanical properties.

### BRIEF DESCRIPTION OF DRAWINGS

To illustrate the technical solutions in the embodiments of the present disclosure or the existing technology more clearly, the drawings to be used in description of the embodiments or the existing technology will be briefly described below. It will be apparent that the drawings in the following description are merely examples or embodiments of the present disclosure, and that those of ordinary skill in the art may obtain other drawings from the provided drawings and apply the present disclosure to other similar scenarios based on the provided drawings without any creative labor. Unless otherwise apparent from the context or stated otherwise, like reference numbers in the figures refer to the same structure or operation.
FIG. 1 is a side view structure diagram of a photovoltaic module according to a first embodiment of the present disclosure.
FIG. 2 is a side view structure diagram of a photovoltaic module according to a second embodiment of the present disclosure.
FIG. 3 is a side view structure diagram of a photovoltaic module according to a third embodiment of the present disclosure.
FIG. 4 is a side view structure diagram of a photovoltaic module according to a fourth embodiment of the present disclosure.
FIG. 5 is a side view structure diagram of a photovoltaic module composite structure according to another embodiment of the present disclosure.
FIG. 6 is a schematic flowchart of a method for preparing a photovoltaic module composite structure according to another embodiment of the present disclosure.

Reference Signs: 1. first photovoltaic front glass; 2. first photovoltaic adhesive film; 3. first cell chip; 4. second photovoltaic adhesive film; 5. first photovoltaic rear glass; 6. stiffening plate; 7. third photovoltaic adhesive film; 8. second cell chip; 9. fourth photovoltaic adhesive film; 10. second photovoltaic front glass; 11. second photovoltaic rear glass; 12. first adhesive layer; 13. second adhesive layer; 14. third photovoltaic rear glass; 15. third cell chip; 16. fifth photovoltaic adhesive film; 17. third photovoltaic front glass; 91. first photovoltaic module; and 92. stiffening member.

### DETAIL DESCRIPTION OF EMBODIMENTS

The present disclosure will be further described in detail below in conjunction with the drawings and embodiments. It should be understood that the specific embodiments described herein are used merely for the purpose of explaining the related application instead of limiting the application. The exemplary embodiments described are merely some, but not all, of the embodiments of the present disclosure. Based on the embodiments of the present disclosure, all the other embodiments obtained by those of ordinary skill in the art without any creative labor fall into the protection scope of the present disclosure.

It should be noted that, for the convenience of description, only the parts related to the related application are shown in the drawings. The embodiments of the present disclosure and features thereof may be combined with each other as long as they are not contradictory.

It should be understood that the terms "system", "apparatus", "unit" and/or "module" are used herein as a method for distinguishing different components, elements, parts, portions or assemblies of different levels. However, other expressions may be used as substitutions for these words as long as they can accomplish the same purpose.

As used in in the present disclosure and in the claims, the terms "a," "an," "the" and/or "said" are not intended to specify singular forms, but may include the plural forms as well, unless the context clearly dictates otherwise. In general, the terms "comprise" and "include" merely suggest presence of the explicitly identified steps or elements which do not constitute an exclusive list, and the method or device may include further steps or elements. An element defined by "comprising a ..." do not exclude the existence of additional identical elements in the process, method, item or device including the element.

In the description of the embodiments of the present disclosure, unless otherwise specified, "/" means "or"; for example, A/B may indicate A or B; and "and/or" as used herein is merely to describe an association relationship of associated objects, which may include three relationships; for example, A and/or B may refer to: A alone, A and B, or B alone. In addition, in the description of the embodiments of the present disclosure, "a plurality of" means two or more.

In the following, the terms "first", "second" are merely used for the purpose of illustration and are not to be construed as indicating or implying a relative importance or implicitly indicating the number of the indicated technical features. Therefore, a feature defined by "first" or "second" may include one or more of the features either explicitly or implicitly.

A flowchart is used herein to illustrate the operations performed by the system according to embodiments of the present disclosure. It should be understood that the preceding or following operations are not necessarily performed in the exact order as shown. Rather, the steps may be processed in a reversed order or simultaneously. Also, other operations may be added to these processes, or one or more operations may be removed from these processes.

In some related technologies, due to poor mechanical properties, applications of the photovoltaic module are limited.

In order to enhance the mechanical properties (e.g. strength) of the photovoltaic module, it is a common practice to increase thicknesses of photovoltaic front and/or rear glass of the photovoltaic module. However, the thickened photovoltaic front glass may lead to a reduced light transmittance, and thus affect the power generation efficiency of the photovoltaic module. Also, the processing difficulty of the thickened photovoltaic front or rear glass is increased.

Therefore, how to obtain a photovoltaic module with enhanced mechanical properties without reducing the power generation efficiency of the photovoltaic module or increasing the processing difficulty has become an urgent technical problem to be solved by those skilled in the art.

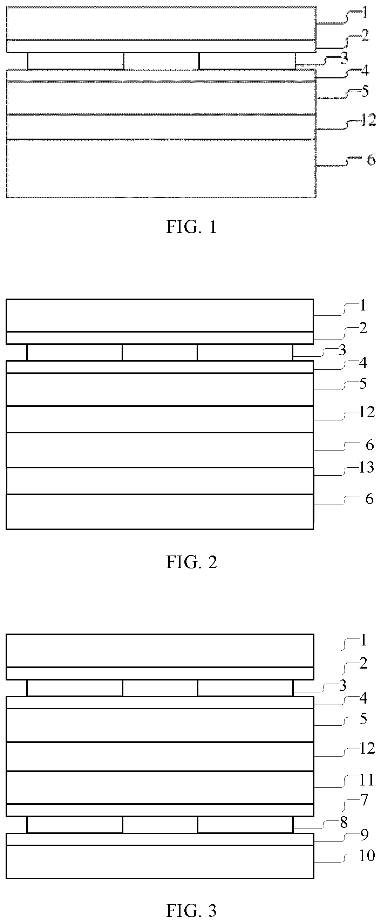

Please refer to FIGs. 1-4.

Some embodiments of the present disclosure disclose a photovoltaic module, including a first photovoltaic module and a stiffening member. The stiffening member is provided on a back surface of the first photovoltaic module and configured to enhance mechanical properties of the first photovoltaic module.

The "photovoltaic module" here refers to a relatively independent product capable of generating electricity with illumination (outputting a voltage under illumination), and includes a first photovoltaic module and a stiffening member.

The "first photovoltaic module" in the "photovoltaic module" according to the embodiments of the present disclosure is also a relatively independent product capable of generating electricity with illumination (i.e., outputting a voltage under illumination), but does not include a stiffening member. Therefore, the "first photovoltaic module" according to the embodiments of the present disclosure may be considered as a product similar to the "photovoltaic module product" in the related technology.

The first photovoltaic module has a front surface and a back surface which are opposite to each other. The front surface is a "light receiving surface" for light to enter when the first photovoltaic module is normally arranged, and the back surface is a "shady surface" opposite to the light receiving surface.

The mechanical properties include strength, hardness, impact toughness, fatigue limit, and the like, especially strength.

The "stiffening member configured to enhance mechanical properties of the first photovoltaic module" means that the first photovoltaic module with the stiffening member (or "the stiffening member and the first photovoltaic module as a whole") has enhanced mechanical properties as compared with a first photovoltaic module without the stiffening member.

In the photovoltaic module according to the present disclosure, the stiffening member is provided on the back surface of the first photovoltaic module. With the stiffening member provided on the back surface of the first photovoltaic module, the light transmittance on the front surface of the first photovoltaic module is not affected, and the power generation efficiency of the first photovoltaic module is ensured. Instead of the thickened front and rear photovoltaic glass, a separate stiffening member is used to enhance the mechanical properties of the first photovoltaic module, which will not increase the processing difficulty of the first photovoltaic module. The stiffening member itself has certain mechanical properties, and when the stiffening member is provided on the back surface of the first photovoltaic module, mechanical properties of the first photovoltaic module and the stiffening member are added to obtain a photovoltaic module with enhanced mechanical properties.

In some embodiments of the present disclosure, the stiffening member is a stiffening plate.

In some embodiments, the stiffening plate has a mechanical property better than the first photovoltaic module, and thus can at least double that mechanical property of the photovoltaic module.

The stiffening plate may be a hollow stiffening plate or a solid stiffening plate. In some embodiments, the stiffening plate is a solid stiffening plate, and with the same material, the solid stiffening plate has better mechanical properties.

In an embodiment where the stiffening member is a stiffening plate, the present disclosure discloses two embodiments of the stiffening member.

In the first embodiment, the stiffening member is a single layer of the stiffening plate. That is, the stiffening member is a stiffening plate.

In the second embodiment, the stiffening member is a stiffening plate assembly including at least two layers of the stiffening plates arranged in a stacked manner. That is, the stiffening member includes a plurality of stacked stiffening plates.

In some embodiments, the stiffening member is connected to the back surface of the first photovoltaic module via a first adhesive layer.

In an embodiment where the stiffening member includes only a single layer of the stiffening plate, the stiffening plate is connected to the back surface of the first photovoltaic module via a first adhesive layer.

In an embodiment where the stiffening member is a stiffening plate assembly, the stiffening plate assembly may also be connected to the back surface of the first photovoltaic module via a first adhesive layer.

In other words, the stiffening member may always be connected to the back surface of the first photovoltaic module via the first adhesive layer regardless of the specific form of the stiffening member.

In an embodiment where the stiffening member is a stiffening plate, the stiffening plate may have a shape the same as, or different from, the first photovoltaic module.

In an embodiment where the stiffening member is a stiffening plate, the stiffening plate may have a size the same as, or different from, the first photovoltaic module.

In an embodiment where the stiffening member is a stiffening plate, the stiffening plate may have a thickness equal to, less than, or greater than the first photovoltaic module.

In an embodiment where the stiffening member is a stiffening plate assembly, the at least two layers of the stiffening plates of the stiffening plate assembly may have the same shape or have different shapes. Specifically, all or some of the stiffening plates constituting the stiffening plate assembly may have the same shape. In some embodiments, all the stiffening plates constituting the stiffening plate assembly have the same shape.

In an embodiment where the stiffening member is a stiffening plate assembly, the at least two layers of the stiffening plates of the stiffening plate assembly may have the same size or have different sizes. Specifically, all or some of the stiffening plates constituting the stiffening plate assembly may have the same shape. Specifically, all or some of the stiffening plates constituting the stiffening plate assembly may have the same size. In some embodiments, all the stiffening plates constituting the stiffening plate assembly have the same size.

In an embodiment where the stiffening member is a stiffening plate assembly, the at least two layers of the stiffening plates of the stiffening plate assembly may be made of the same material or made of different materials. Specifically, all or some of the stiffening plates constituting the stiffening plate assembly may be made of the same material. In some embodiments, all the stiffening plates constituting the stiffening plate assembly are made of the same material.

In an embodiment where the stiffening member is a stiffening plate assembly, each stiffening plate constituting the stiffening plate assembly may have a shape the same as, or different from, the first photovoltaic module. In some embodiments, each stiffening plate constituting the stiffening plate assembly has a shape the same as the first photovoltaic module.

In an embodiment where the stiffening member is a stiffening plate assembly, each stiffening plate constituting the stiffening plate assembly may have a size the same as, or different from, the first photovoltaic module. In some embodiments, each stiffening plate constituting the stiffening plate assembly has a size the same as the first photovoltaic module.

The stiffening member (such as a single layer of the stiffening plate or a stiffening plate assembly) is connected to the back surface of the first photovoltaic module via the first adhesive layer. In other words, the stiffening member as a whole may be bonded to the back surface of the first photovoltaic module; and/or any two adjacent layers of the stiffening plates of the stiffening plate assembly are connected via a second adhesive layer. That is, different stiffening plates in the stiffening plate assembly may be mutually bonded as well.

The stiffening member, including either a single layer of the stiffening plate or a stiffening plate assembly, may be made of a glass plate, a concrete plate, a steel plate or a plastic plate.

The stiffening member, including either a single layer of the stiffening plate or a stiffening plate assembly, may be a plate of a uniform thickness or a varied thickness. The stiffening plate of a varied thickness may be a stiffening plate with a thickness gradually increased, or a stiffening plate with different thicknesses at adjacent positions, or a stiffening plate with two adjacent layers of the stiffening plates in concave-convex correspondence, through which a uniform thickness across the stiffening member is finally reached. With such structures, the application range of the photovoltaic module can be further expanded.

The stiffening plate is not limited to a plate-shaped structure made of the above materials (which does not mean that the stiffening plate is necessarily a "flat plate" of a large area), but may be a plate-shaped structure made of other materials, which is not particularly limited herein.

In an embodiment where the stiffening member of the photovoltaic module is a single layer of the stiffening plate or a stiffening plate assembly, only the light receiving surface (front surface) of the first photovoltaic module serves as the light receiving surface of the photovoltaic module.

In other embodiments of the present disclosure, the stiffening member is a second photovoltaic module, in which the mechanical properties of the first photovoltaic module are enhanced by the second photovoltaic module acting as a stiffening member.

Specifically, a back surface (shady surface) of the second photovoltaic module is connected to the back surface of the first photovoltaic module. In the photovoltaic module according to the embodiment, the light receiving surfaces of both the first photovoltaic module and the second photovoltaic module can function so that the power generation efficiency of the photovoltaic module can be increased while the mechanical properties of the photovoltaic module are enhanced.

The "second photovoltaic module" is also a relatively independent product capable of generating electricity with illumination (i.e., outputting a voltage under illumination). Therefore, the "second photovoltaic module" according to the embodiments of the present disclosure may be also considered as a product similar to the "photovoltaic module product" in the related technology, and the second photovoltaic module itself in the embodiment of the present disclosure also serves as a stiffening member.

Since the back surface of the first photovoltaic module is connected to the back surface of the second photovoltaic module, the front surfaces for incident light (light receiving surfaces) of the two are facing away from each other. Therefore, both sides of the whole photovoltaic module are light receiving surfaces, but for each of the first photovoltaic module and the second photovoltaic module, it still has a light receiving surface on one side and a shady surface on the other side.

In some embodiments, the second photovoltaic module may have a shape the same as, or different from, the first photovoltaic module. In some embodiments, the second photovoltaic module has a shape the same as the first photovoltaic module.

In some embodiments, the second photovoltaic module may have a size the same as, or different from, the first photovoltaic module. In some embodiments, the second photovoltaic module has a size the same as the first photovoltaic module.

In some embodiments, the second photovoltaic module may have a thickness the same as, or different from, the first photovoltaic module, which may be specifically selected by those skilled in the art based on actual needs.

In some embodiments, the first photovoltaic module and the second photovoltaic module may be of the same type or different types.

In an embodiment where the first photovoltaic module and the second photovoltaic module are the same type, the first photovoltaic module has a composite structure the same as the second photovoltaic module. In an embodiment where the first photovoltaic module and the second photovoltaic module are of different types, the first photovoltaic module may have a composite structure the same as, or different from, the second photovoltaic module.

Furthermore, in an embodiment where the first photovoltaic module and the second photovoltaic module are of different types but have the same composite structure, the first photovoltaic module and the second photovoltaic module adopt different types of cell chips, where the cell chip used in the first photovoltaic module may be a crystalline silicon cell chip, and the second photovoltaic module may be a thin film solar cell module. In an embodiment where the first photovoltaic module and the second photovoltaic module are of different types and have different composition structures, the first photovoltaic module may be a crystalline silicon solar cell module, and the second photovoltaic module may be a thin film solar cell module.

Different structures of stiffening members may be applied to different scenarios.

In an embodiment where the stiffening member is a second photovoltaic module, the photovoltaic module includes a first photovoltaic module and a second photovoltaic module. A back surface of the first photovoltaic module is connected to a back surface of the second photovoltaic module, and both sides of the photovoltaic module may receive light.

In an embodiment where both the first photovoltaic module and the second photovoltaic module are crystalline silicon solar photovoltaic modules, the photovoltaic module is suitable for a scenario where light (sunshine) mainly come from one direction, such as a highway.

In an embodiment where the first photovoltaic module is a crystalline silicon solar cell module and the second photovoltaic module is a thin film solar cell module, the photovoltaic module is suitable for a use environment with one side facing indoors and the other side facing outdoors, i.e., a scenario with light rays (sunlight and lamplight) from two directions. Specifically, the first photovoltaic module faces outdoors, and the second photovoltaic module faces indoors.

As shown in FIG. 1, an embodiment where the stiffening member is a single layer of the stiffening plate is shown. The photovoltaic module sequentially includes, from top to bottom, first photovoltaic front glass 1, a first photovoltaic adhesive film 2, a first cell chip 3, a second photovoltaic adhesive film 4, first photovoltaic rear glass 5, a first adhesive layer 12, and a stiffening plate 6.

The first photovoltaic front glass 1, the first photovoltaic adhesive film 2, the first cell chip 3, the second photovoltaic adhesive film 4, and the first photovoltaic rear glass 5 form a first photovoltaic module.

In this embodiment, the stiffening plate 6 constituting the stiffening member is relatively thick, with a thickness of 5 to 8mm, and has a printable back surface.

In an embodiment where the stiffening member is a single layer of the stiffening plate, the stiffening plate 6 may be a one-piece stiffening plate flatly laid on a back surface of the first photovoltaic rear glass 5 (i.e., the back surface of the first photovoltaic module). The stiffening plate 6 may also include a plurality of strip-shaped or block-shaped stiffening plates arranged in a parallel or non-parallel manner along the back surface of the first photovoltaic rear glass 5.

In an embodiment where the stiffening member is a single layer of the stiffening plate 6, the stiffening plate 6 may be directly manufactured through a cutting or shaping process, and the specific process may be selected according to the material of the stiffening plate and the requirement of the person skilled in the art, which is not particularly limited herein.

The connection between the stiffening plate 6 and the first photovoltaic module may be carried out in an autoclave (e.g., bonding via a first adhesive layer 12).

As shown in FIG. 2, an embodiment where the stiffening member is a stiffening plate assembly is shown. The photovoltaic module sequentially includes, from top to bottom, first photovoltaic front glass 1, a first photovoltaic adhesive film 2, a first cell chip 3, a second photovoltaic adhesive film 4, first photovoltaic rear glass 5, a first adhesive layer 12, a stiffening plate 6, a second adhesive layer 13, and a stiffening plate 6.

The first photovoltaic front glass 1, the first photovoltaic adhesive film 2, the first cell chip 3, the second photovoltaic adhesive film 4, and the first photovoltaic rear glass 5 form a first photovoltaic module; and the two stiffening plates 6 constitute a stiffening plate assembly.

In this embodiment, a stiffening plate assembly including two layers of the stiffening plates 6 is disclosed.

The stiffening plate assembly includes at least two layers of the stiffening plates 6 arranged in a stacked manner along a direction perpendicular to a plane where the first photovoltaic rear glass 5 is located. In this embodiment, each stiffening plate 6 may have a thickness reduced accordingly, and with the addition of mechanical properties of the at least two layers of the stiffening plates 6, the final mechanical properties required of the photovoltaic module can be achieved.

In the embodiment where the stiffening plate assembly includes at least two layers of the stiffening plates 6 arranged in a stacked manner, a suitable number of layers of the stiffening plates 6 can be selected according to the actual needs, so as to flexibly adjust the mechanical properties of the photovoltaic module.

In an embodiment where the stiffening member is a stiffening plate assembly, the stiffening plates 6 constituting the stiffening plate assembly may be manufactured through a cutting or shaping process, and the specific process may be selected according to the material of the stiffening plates 6 and the requirement of the person skilled in the art, which is not particularly limited herein.

If the stiffening plate assembly is relatively thinner, the stiffening plate assembly may be manufactured in a laminator or autoclave; and if the stiffening plate assembly is relatively thicker, the stiffening plate assembly may be manufactured by an autoclave.

The connection between the stiffening plate assembly and the first photovoltaic module may be carried out in an autoclave (e.g., bonded via a first adhesive layer 12).

Alternatively, the respective stiffening plates 6 in the stiffening plate assembly are laminated onto the back surface of the first photovoltaic module, and then placed in an autoclave as a whole for connection (e.g., bonded via a second adhesive layer 13).

The first adhesive layer 12 and the second adhesive layer 13 may be photovoltaic adhesive films, or adhesive films with low requirements on electrical properties. For example, the first adhesive layer 12 and the second adhesive layer 13 may be building adhesive film. The building adhesive film has a lower cost than the photovoltaic adhesive film, and has better viscosity, flexibility and impact resistance.

As shown in FIG. 3, an embodiment where the stiffening member is a second photovoltaic module is shown, in which the first photovoltaic module and the second photovoltaic module have the same composite structure. The first photovoltaic module includes first photovoltaic front glass 1, a first photovoltaic adhesive film 2, a first cell chip 3, a second photovoltaic adhesive film 4, and first photovoltaic rear glass 5. The second photovoltaic module includes second photovoltaic rear glass 11, a third photovoltaic adhesive film 7, a second cell chip 8, a fourth photovoltaic adhesive film 9, and second photovoltaic front glass 10. A back surface of the first photovoltaic rear glass 5 is connected to a back surface of the second photovoltaic rear glass 11 via a first adhesive layer 12.

In this embodiment, an integral photovoltaic module with enhanced mechanical properties is obtained by means of two smaller stacked photovoltaic modules.

The connection between the second photovoltaic module and the first photovoltaic module may be performed in an autoclave.

In the photovoltaic module shown in FIG. 3, the first cell chip 3 and the second cell chip 8 may be of the same type or different types (accordingly, the first photovoltaic module and the second photovoltaic module may be of the same type or different types). The photovoltaic module with the same type of cell chips is suitable for a working environment where light receiving conditions on two sides of the photovoltaic module are similar, and the photovoltaic module with different types of cell chips is suitable for a working environment where the light receiving conditions on two sides of the photovoltaic module are different. Those skilled in the art may select the appropriate cell chips according to the application scenario of the photovoltaic module, thereby expanding the application range of the photovoltaic module.

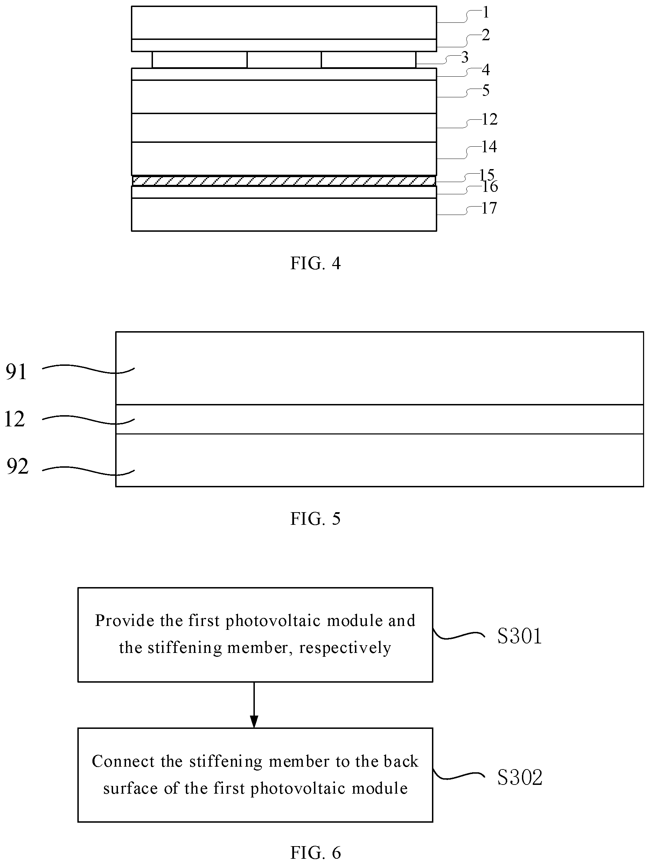

As shown in FIG. 4, an embodiment where the stiffening member is a second photovoltaic module is shown, in which the disclosed first photovoltaic module and second photovoltaic module have different composition structures. The first photovoltaic module includes first photovoltaic front glass 1, a first photovoltaic adhesive film 2, a first cell chip 3, a second photovoltaic adhesive film 4, and first photovoltaic rear glass 5. The second photovoltaic module includes third photovoltaic rear glass 14, a third cell chip 15, a fifth photovoltaic adhesive film 16, and third photovoltaic front glass 17. A back surface of the first photovoltaic rear glass 5 is connected to a back surface of the third photovoltaic rear glass 17 via a first adhesive layer 12. The third cell chip 15 is a thin film cell, and thus, the second photovoltaic module is a thin film solar cell module.

The thin film cell as the third cell chip 15 may have various forms.

Current thin film cells include amorphous silicon thin film solar cells, copper indium gallium selenide (CIGS) thin film solar cells, copper indium selenide (CIS) thin film solar cells, cadmium telluride thin film solar cells, gallium arsenide thin film solar cells, and the like.

The amorphous silicon thin film solar cell is a thin film solar cell mainly consisting of an amorphous silicon compound, which has the advantages of low production cost, short energy return period, good performance at a high temperature, good response in dim light, high photoelectric efficiency and the like.

The CIGS thin film solar cell and the CIS thin film solar cell have the advantages of low cost, high conversion efficiency, stability close to that of a monocrystalline silicon solar cell and the like.

The cadmium telluride thin film solar cell, also called CdTe cell, is a thin film solar cell based on a heterojunction of p-type cadmium telluride (CdTe) and n-type cadmium sulfide (CdS), and has the advantages of ideal band gap, high light absorbance, high conversion efficiency, stable performance, low manufacturing cost and the like.

Compared with a silicon-based solar cell (such as an amorphous silicon thin film solar cell), the gallium arsenide thin film solar cell has a higher photoelectric conversion rate and better temperature resistance.

According to the present disclosure, a stiffening plate 6, a stiffening plate assembly or a second photovoltaic module is used as a stiffening member, while the first photovoltaic module remains unchanged, and a photovoltaic module with enhanced mechanical properties is obtained through a combination of the stiffening plate 6, the stiffening plate assembly or the second photovoltaic module with the first photovoltaic module, which is easy to obtain and does not involve much additional cost compared with the method of increasing the thicknesses of the first photovoltaic front glass 1 and the second photovoltaic rear glass 5.

In the present disclosure, the first photovoltaic front glass 1 of the first photovoltaic module has a thickness of 1.5 to 3.5 mm; the second photovoltaic front glass 10 of the second photovoltaic module has a thickness of 1.5 to 3.5 mm, or the third photovoltaic front glass 17 has a thickness of 1.5 to 3.5 mm. These glass components are all ultra-clear glass of a conventional thickness, so that the light transmittance can be ensured, and since the processing technology is relatively mature, not much additional cost will be involved.

The first photovoltaic front glass 1, the second photovoltaic front glass 10 and the third photovoltaic front glass 17 may each adopt ultra-clear glass, and in some embodiments, the ultra-clear glass is ultra-clear embossed glass. The ultra-clear glass, due to the high light transmittance thereof, will not affect the efficiency of the photovoltaic module.

The first photovoltaic rear glass 5, the second photovoltaic rear glass 11 and the third photovoltaic rear glass 14 may each adopt screen printed glass. The first photovoltaic rear glass 5, the second photovoltaic rear glass 11 and the third photovoltaic rear glass 14 are not limited to screen printed glass, and other types of glass suitable for the photovoltaic field may be used.

The first photovoltaic adhesive film 2, the second photovoltaic adhesive film 4, the third photovoltaic adhesive film 7, and the fourth photovoltaic adhesive film 9 are all photovoltaic adhesive films made of EVA, POE, PVB or PVA, or the like.

Referring to FIG. 5, some embodiments of the present disclosure further disclose a photovoltaic module composite structure, including: a first photovoltaic module 91 configured to generate electricity with illumination; and a stiffening member 92 connected to a back surface of the first photovoltaic module 91. The back surface is a surface of the first photovoltaic module 91 facing away from a light receiving surface; and an overall strength of the structure formed by the stiffening member 92 and the first photovoltaic module 91 is greater than a strength of the first photovoltaic module 91.

An embodiment of the present disclosure further provides a photovoltaic module product (photovoltaic module composite structure).

The photovoltaic module composite structure includes a first photovoltaic module 91 (such as a photovoltaic module in the related technology) capable of generating electricity with illumination, as well as a stiffening member 92. The stiffening member 92 is a device independent of the first photovoltaic module 91, but is connected to a back surface of the first photovoltaic module 91.

Due to the presence of the stiffening member 92, an overall strength of the structure formed by "the first photovoltaic module 91+ the stiffening member 92" is higher than a strength of "the first photovoltaic module 91" alone.

Therefore, the "photovoltaic module composite structure" in the embodiment of the present disclosure has a higher overall strength and a wider application range. Meanwhile, the thicknesses of the front and rear glass of the first photovoltaic module 91, which is actually used for emitting light, are not changed, namely the structure of the first photovoltaic module may be the same as that in the related technology, so that the incident light is not affected, and the processing difficulty is not changed. Moreover, the stiffening member 92 is placed on the back surface (shady surface) of the first photovoltaic module 91, so that the incident light on the first photovoltaic module 91 is not affected.

In some embodiments, the stiffening member 92 includes a stiffening structural member.

As a manner provided in an embodiment of the present disclosure, the stiffening member 92 may be a structural member (stiffening structural member) that "only" plays a role of "stiffening" (with no electrical, optical functions or the like), and thus, the stiffening member 92 may be a plate-shaped, block-shaped, strip-shaped structure, or the like composed of a material having a relatively high strength.

In some embodiments, the stiffening member 92 includes a second photovoltaic module configured to generate electricity with illumination.

Alternatively, as a manner provided in an embodiment of the present disclosure, the stiffening member 92 itself may be a second photovoltaic module (such as a photovoltaic module in the related technology) capable of generating electricity with illumination, which plays a role of generating electricity and a role of stiffening at the same time. That is, there are two "photovoltaic modules" capable of generating electricity independently in the "photovoltaic module composite structure".

When the stiffening member 92 adopts a second photovoltaic module, a side of the second photovoltaic module that contacts the back surface of the first photovoltaic module 91 may be a front surface of the second photovoltaic module (i.e., the second photovoltaic module may generate electricity with light passing through the first photovoltaic module 91), or a back surface of the second photovoltaic module (i.e., the second photovoltaic module may generate electricity with light incident on the other side).

It should be understood that when the back surface of the second photovoltaic module is in contact with the back surface of the first photovoltaic module 91, the first photovoltaic module 91 may also be considered to some extent as the stiffening member 92 for the second photovoltaic module.

It should be understood that it is also possible for the stiffening member 92 to be a structure that otherwise functions (e.g., as an optical film).

In some embodiments, the stiffening member 92 is bonded to the back surface of the first photovoltaic module 91 via a first adhesive layer 12.

As a manner provided in an embodiment of the present disclosure, the stiffening member 92 (e.g., a stiffening structural member or a second photovoltaic module) may be connected to the back surface of the first photovoltaic module 91 by way of an adhesive.

It should be understood that it is also possible that the stiffening member 92 is connected to the back surface of the first photovoltaic module 91 by other means, such as snap fit.

Referring to FIGs. 5 and 6, some embodiments of the present disclosure further disclose a method for preparing a photovoltaic module composite structure, where the photovoltaic module composite structure is the photovoltaic module composite structure according to any embodiment of the present disclosure, and the method includes the following steps S301 to S302.

At S301, providing the first photovoltaic module 91 and the stiffening member 92, respectively.

At S302, connecting the stiffening member 92 to the back surface of the photovoltaic module.

In preparation of the photovoltaic module composite structure according to the embodiments of the present disclosure, the first photovoltaic module 91 and the stiffening member 92 may be provided (e.g., prepared) separately in advance, and then the stiffening member 92 is connected (e.g., bonded) to the back surface of the first photovoltaic module 91.

The foregoing description is merely illustrative of the preferred embodiments of the present disclosure and the principles of the technology employed, and is not intended to limit the disclosure. Those skilled in the art knows well that various modifications and changes may be made to the present disclosure. The application scope of the present disclosure is not limited to the technical solutions formed by specific combinations of the above technical features, but shall cover any other technical solution formed by any combination of the above technical features or equivalent features thereof without departing from the above concepts of the present disclosure, such as technical solutions formed by replacing the above features with technical features having similar functions disclosed in the present disclosure (but not limited thereto).

## Claims

1. A photovoltaic module, comprising a first photovoltaic module and a stiffening member, wherein the stiffening member is provided on a back surface of the first photovoltaic module and configured to enhance mechanical properties of the first photovoltaic module.

2. The photovoltaic module according to claim 1, wherein the stiffening member is a stiffening plate.

3. The photovoltaic module according to claim 2, wherein
the stiffening member is a single layer of the stiffening plate;
or,
the stiffening member is a stiffening plate assembly comprising at least two layers of the stiffening plates arranged in a stacked manner.

4. The photovoltaic module according to claim 3, wherein the at least two layers of the stiffening plates of the stiffening plate assembly have the same shape.

5. The photovoltaic module according to claim 3, wherein the at least two layers of the stiffening plates of the stiffening plate assembly have the same size.

6. The photovoltaic module according to claim 3, wherein the at least two layers of the stiffening plates of the stiffening plate assembly are made of the same material.

7. The photovoltaic module according to claim 3, wherein any two adjacent layers of the stiffening plates of the stiffening plate assembly are connected via a second adhesive layer.

8. The photovoltaic module according to any one of claims 2 to 7, wherein the stiffening plate is a glass plate, a concrete plate, a steel plate, or a plastic plate.

9. The photovoltaic module according to claim 1, wherein the stiffening member is a second photovoltaic module, and a back surface of the second photovoltaic module is connected to the back surface of the first photovoltaic module.

10. The photovoltaic module according to claim 9, wherein the second photovoltaic module and the first photovoltaic module are of the same type or different types.

11. The photovoltaic module according to claim 10, wherein the second photovoltaic module is a crystalline silicon solar cell module.

12. The photovoltaic module according to claim 10, wherein the second photovoltaic module is a thin film solar cell module.

13. The photovoltaic module according to claim 1, wherein
the stiffening member is connected to the back surface of the first photovoltaic module via a first adhesive layer.

14. The photovoltaic module according to claim 1, wherein
the mechanical properties comprise strength.

15. A photovoltaic module composite structure, comprising:
a first photovoltaic module configured to generate electricity with illumination; and
a stiffening member connected to a back surface of the first photovoltaic module; wherein the back surface is a surface of the first photovoltaic module facing away from a light receiving surface; and
an overall strength of the stiffening member and the first photovoltaic module is greater than a strength of the first photovoltaic module.

16. The photovoltaic module composite structure according to claim 15, wherein
the stiffening member comprises a stiffening structural member;
or,
the stiffening member comprises a second photovoltaic module configured to generate electricity with illumination.

17. The photovoltaic module composite structure according to claim 15, wherein
the stiffening member is bonded to the back surface of the first photovoltaic module via a first adhesive layer.

18. A method for preparing a photovoltaic module composite structure, wherein the photovoltaic module composite structure is the photovoltaic module composite structure according to any one of claims 15 to 17, and the method comprises:
providing the first photovoltaic module and the stiffening member, respectively; and
connecting the stiffening member to the back surface of the first photovoltaic module.
